# EUROPÄISCHE PATENTSCHRIFT

(11) **EP 2 333 955 B1**
(45) Veröffentlichungstag und Bekanntmachung des Hinweises auf die Patenterteilung: **13.03.2013**
(21) Anmeldenummer: 09178863.8
(22) Anmeldetag: 11.12.2009
(51) Int. Cl.: H03K 7/08, H03K 3/017, H02M 3/157, H02M 3/335

(54) **Verfahren und Vorrichtung zum Erzeugen einer pulsweiten modulierten Signalfolge**
Method and device for generating a pulse-width modulated signal sequence
Procédé et dispositif destinés à la production d'une sequence de signal à modulation d'impulsion en durée

(43) Veröffentlichungstag der Anmeldung: 15.06.2011
(73) Patentinhaber: Siemens Aktiengesellschaft, 80333 München (DE)
(72) Erfinder: Wallner, Lorenz, 90766 Fürth (DE); Gagsteiger, Willi, 90765 Fürth (DE)

(56) Entgegenhaltungen:
- US-A1- 2006 015 274
- US-A1- 2009 066 384
- US-B1- 6 198 264
- US-B1- 6 911 808

## Beschreibung

Die Erfindung betrifft zum Einen ein Verfahren zum Erzeugen einer pulsweiten modulierten Signalfolge bei dem eine Ausgangsspannung während einer Periode zwischen einem ersten Wert und einem zweiten Wert wechselt, wobei mittels eines vorgebbaren Sollwertes eine erste Zeitdauer, während derer die Ausgangsspannung den ersten Wert annimmt, ermittelt wird.

Zum Anderen betrifft die Erfindung ein Automatisierungssystem mit einem Automatisierungsgerät und mit einer Vorrichtung zur Ausgabe einer pulsweiten modulierten Signalfolge bei dem eine Ausgangsspannung während einer Periode zwischen einem ersten Wert und einem zweiten Wert wechselt, wobei die Vorrichtung ein Mittel zum Erzeugen der Signalfolge aufweist, welches ausgestaltet ist mittels eines vorgebbaren Sollwertes eine erste Zeitdauer, während derer die Ausgangsspannung den ersten Wert annimmt, zu berechnen.

Derartige Verfahren und Vorrichtungen sind dem Fachmann der Automatisierungstechnik bereits bekannt. So ist beispielsweise in der Leistungselektronik bekannt, eine Pulsweitenmodulation für die Leistungselektronik einzusetzen, da an Leistungsschaltern möglichst wenig Verlustleistung abgegeben werden soll, werden diese in nur zwei Kernpunkten betrieben, nämlich voll sperrend oder voll durchgeschaltet. Ein Mittelwert der Spannung ergibt sich dabei durch das Verhältnis Einschaltzeit zu Periodendauer. Einsatzbereiche sind auch Gleichstromsteller, Frequenzumrichter bzw. Elektromotoren, Heizelemente, Dimmer, Schaltnetzteile und CPU-Lüfter.

In der US 2006/0015274 A1 wird ein Verfahren zum Betreiben eines Schaltnetzteils vorgeschlagen.

Zur Erzeugung eines PWM-Signals aus digital vorliegenden Daten kommen geeignete Zähler-/Vergleicherschaltungen zum Einsatz. Bereits bekannte Mikrocontroller enthalten beispielsweise direkt ein PWM-Modul oder unterstützen durch geeignete Timer-Funktionen deren Implementierung.

Auch werden beispielsweise in der Automatisierungstechnik Puls-Module zum intelligenten Ansteuern von Stellgliedern und Ventilen verwendet. In Verbindung mit einem Automatisierungsgerät und einer Regelungs-Software kann das Puls-Modul pulsweiten modulierte Stellwerte ausgeben.

Von Nachteil ist es, dass man mit den bekannten Verfahren und Vorrichtungen ein Puls-/Pausenverhältnis eines PWM-Signals nur zu bestimmten Zeitpunkten, beispielsweise immer zu Beginn einer PWM-Periode, neu einstellen kann. Das bedeutet, dass wenn ein neuer Sollwert für die Einstellung einer neuen PWM-Signal-Ausgabe bereitsteht, der Fall auftreten kann, dass der neu berechnete Sollwert nicht direkt übernommen werden kann. Es entsteht also eine Totzeit zwischen der Sollwertberechnung und der Ausgabe eines neuen PWM-Signals. Diese Totzeit macht sich umso mehr bemerkbar, wenn das Automatisierungsgerät, in dem die Sollwertberechnung abläuft, über einen Feldbus mit der Ausgabeeinheit, welche das eigentliche PWM-Signal erzeugt, verbunden ist. Sowohl die Totzeit selbst als auch Schwankungen bei der Regelung sind beim Stand der Technik von Nachteil.

Es ist die Aufgabe der Erfindung, ein Verfahren sowie ein system bereitzustellen, welche es ermöglichen, die genannte Totzeit zu minimieren.

Bei dem eingangs genannten Verfahren wird die Aufgabe durch die Merkmale des Anspruchs 1 gelöst. Durch die Synchronisation wird die Totzeit von der Sollwertberechnung bis zur Ausgabe einer neuen Signalfolge an beispielsweise ein Stellglied in einem Prozess minimiert. Dies wird dadurch erreicht, dass die Erzeugung der Signalfolge mit dem Eintreffen eines neuen Sollwertes aus der Sollwertberechnung derart synchronisiert ist, dass der Sollwert vorzugsweise nahezu zu dem Zeitpunkt zur Verfügung steht, an dem eine Periode beendet ist oder kurz vor ihrer Beendung steht. Vorzugsweise am Ende einer Periode kann nämlich eine neue Periode ausgegeben werden und diese neue Periode kann dann aus einem neuen Tastverhältnis zusammensetzen. Das Verhältnis zwischen Pulsdauer und Periode wird in der Pulsweitenmodulation als Tastverhältnis bezeichnet. Dabei entspricht die erste Zeitdauer der Einschaltzeit und die Zeitdauer der Periode abzüglich der ersten Zeitdauer dem Tastverhältnis T.

Die Sollwertberechnung wird in dem Automatisierungsgerät durchgeführt und der Sollwert zu Zeitpunkten bereitgestellt, welche ganzzahligen vielfachen der Periode entsprechen. Bekannterweise wird ein PWM-Signal beispielsweise durch einen Timer eines Mikrocontrollers realisiert. Dieser Timer läuft dabei unabhängig von der Sollwertberechnung, die vorzugsweise zyklisch in dem Automatisierungsgerät durchgeführt wird. Das Betriebssystem des Automatisierungsgerätes stellt dabei sicher, dass die Sollwertberechnung immer synchron zum Takt eines Feldbusses ausgeführt wird. Wenn nun der neue Sollwert vorzugsweise immer zu Zeitpunkten bereitgestellt wird an dem die Periode oder mehrere Perioden ihr Ende haben, kann der Sollwert zur Berechnung einer neuen Signalfolge jeweils ohne Totzeit herangezogen werden da der Beginn der Perioden der Ausgabe ebenfalls auf den Takt des Feldbusses synchronisiert wird.

Der Sollwert wird über einen Regelalgorithmus bereitgestellt und die Ausgangsspannung mittels einer Zustandsgröße des Stellgliedes geregelt. Hierbei ist es von Vorteil, wenn die Erfassung der Zustandsgröße derart synchronisiert wird, dass für die Zeitdauer einer Periode eine Mittelwertbildung für die Zustandsgröße durchgeführt wird. Wird als Zustandsgröße beispielsweise der durch das Stellglied fließende Strom herangezogen, so wird bei einer Synchronisation der Strommessung auf die Ausgabe des PWM-Signals, welche ebenfalls synchronisiert ist, dafür Sorge getragen, dass Einschwingvorgänge des Stromes innerhalb einer Periode herausgefiltert werden. Dadurch wird die Qualität der Messwerte für eine Stromregelung verbessert.

Wird beispielsweise als Stellglied ein Ventil genutzt, so ist es erwünscht, dass die Stellung eines Kolbens im Ventil möglichst genau einstellbar ist. Die Schwierigkeit besteht darin, dass bei einer gleichen PWM-Signaleinstellung sich der Kolben auf eine andere Position einstellen kann. Dies ist dadurch bedingt, dass das Ventil kalt oder warm sein kann. Aufgrund des temperaturabhängigen Widerstandes der Magnetspule herrscht ein unterschiedlicher Stromfluss, welcher zu unterschiedlichen Stellkräften führt. Die Stromregelung sorgt dabei dafür, dass die Stellung des Kolbens im Ventil unabhängig von der Temperatur wirkt. Über einen Regelkreis wird dafür gesorgt, dass das PWM-Signal immer so erzeugt wird, dass sich in dem Ventil der gewünschte Strom einstellt.

Bei dem eingangs genannten Automatisierungssystem mit einem Automatisierungsgerät und mit einer Vorrichtung wird die genannte Aufgabe durch die Merkmale des Anspruchs 3 gelöst. Solch eine Vorrichtung stellt beispielsweise ein Puls-Modul dar, welches die Ansteuerung von Stellgliedern und Ventilen z.B. zum Dosieren, Verstellen und Regeln, ermöglicht. Das nun in der Vorrichtung vorhandene Synchronisationsmittel ermöglicht die Übernahme eines neuen Sollwertes für eine neue Berechnung einer Signalfolge. Durch die Synchronisation ist sichergestellt, dass eine neue Periode genau dann beginnt bzw. kurz vorher, wenn ein neuer Sollwert kommt bzw. wenn er erwartet wird.

Das Synchronisationsmittel weist dazu einen Eingang auf, an welchen ein Synchronisationssignal anschaltbar ist. Dieses anschaltbare Synchronisationssignal kann beispielsweise aus dem Taktsignal eines an die Vorrichtung angeschlossenen Feldbusses gewonnen werden und zur Synchronisation in das Synchronisationsmittel weitergeleitet werden.

In einer weiteren Ausgestaltung ist das Synchronisationsmittel derart ausgestaltet, dass die Ausgabe der Signalfolge zu Zeitpunkten durchführbar ist, welche ganzzahligen vielfachen der Periode entsprechen. Wird als Synchronisationsmittel beispielsweise ein frei programmierbarer Baustein, wie beispielsweise ein ASIC oder ein Mikro-Controller, verwendet, so kann durch eine entsprechende Programmierung die Vorgabe der ganzzahligen Vielfachen der Periode in dem Baustein implementiert werden.

In einer weiteren Optimierung der Vorrichtung weist diese ein Messmittel zum Messen einer Zustandsgröße eines Stellgliedes auf. Die Messmittel ermöglichen es, direkt in der Vorrichtung eine Messung an dem Stellglied durchzuführen. Mit dem Messmittel kann ein Regelkreis aufgebaut werden und durch diesen Regelkreis kann die zuvor genannte Beeinflussung durch beispielsweise unterschiedliche Temperaturen an dem Stellglied kompensiert werden. Beispielsweise kann so bei einem Proportionalventil durch eine Strommessung der mittlere Strom, mit dem die Spule im Ventil bestromt wird, eingestellt werden und damit die gewünschte Ventilstellung festgelegt werden.

Um die Qualität der Regelung zu verbessern, ist zwischen dem Messmittel und dem Synchronisationsmittel eine Synchronisationsverbindung angeordnet, wobei die Erfassung der Zustandsgröße derart synchronisiert wird, dass für die Zeitdauer einer Periode eine Mittelwertbildung für die Zustandsgröße durchgeführt wird. Je nach angeschlossenem Verbraucher finden hinsichtlich des Stromes während einer PWM-Periode mehr oder weniger ausgeprägte Einschwingvorgänge statt. Bei einer Istwerterfassung für die Regelung sind diese Einschwingvorgänge störend. Zweckmäßigerweise wird ein Mittelwert über die Dauer einer PWM-Periode gebildet, so dass die periodischen Einschwingvorgänge vollständig herausgefiltert werden. Dies wird durch eine Synchronisierung der Strommessung auf die Ausgabe der PWM-Signale ermöglicht.

Um eine Inbetriebnahme der Vorrichtung zu erleichtern, ist das Synchronisationsmittel dazu ausgestaltet, Eigenschaften des Synchronisationssignals auszuwerten und an die Eigenschaften angepasste Parameter für die Signalfolge bereitzustellen. Als Parameter für die Signalfolge sind zu nennen die erste Zeitdauer, die Zeitdauer der Gesamtlänge der Periode, also das Tastverhältnis, der erste Wert der Ausgangsspannung, der zweite Wert der Ausgangsspannung und gegebenenfalls eine Wiederholfrequenz, sowie die Bestimmung einer Anzahl an Vielfachen, welche ganzzahligen Vielfachen der Periodenlängen entsprechen, d.h. die Vorrichtung ist mit ihrem Synchronisationsmittel dazu ertüchtigt, dass aufgrund einer Anpassungsprogrammierung gewünschte Parameter automatisch in dem Synchronisationsmittel für die Berechnung der Synchronisierung bereitgestellt werden.

Ein Ausgestaltungsbeispiel wird anhand der Zeichnungen näher erläutert. Es zeigen:
- FIG 1: eine Vorrichtung zur Ausgabe einer pulsweiten modulierten Signalfolge in einem Automatisierungsverbund,
- FIG 2: ein Prinzipbild einer Regelung mit einer Vorrichtung zur Ausgabe einer pulsweiten modulierten Signalfolge,
- FIG 3: ein Schema für eine taktsynchrone Ausgabe der Signalfolge und
- FIG 4: ein Schema einer synchronisierten Strommessung.

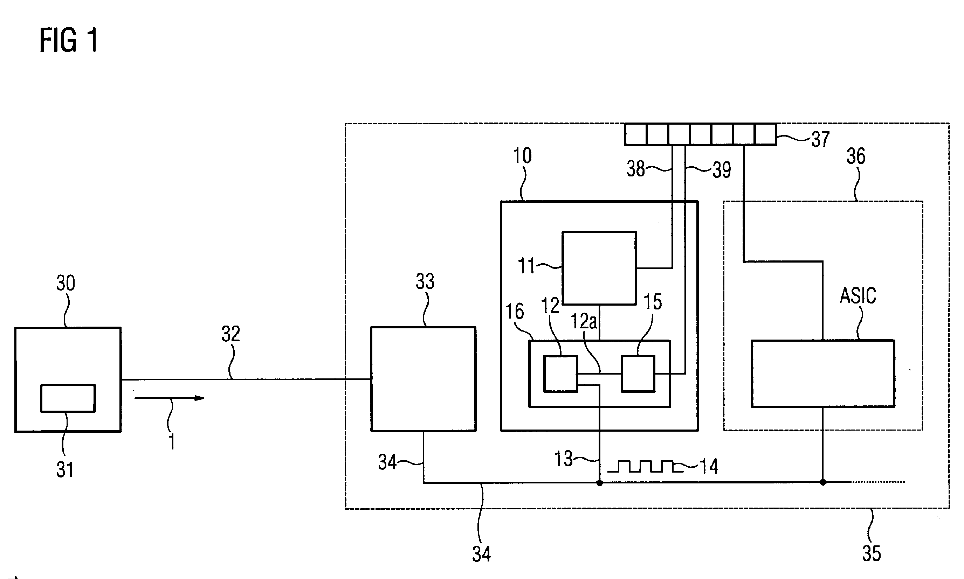

Gemäß FIG 1 ist in einer Prinzipdarstellung ein Automatisierungsgerät 30 im Zusammenspiel mit einer Vorrichtung 10 dargestellt. Die Vorrichtung 10 zur Ausgabe einer pulsweiten modulierten Signalfolge S bei dem eine Ausgangsspannung U während einer Periode T zwischen einem ersten Wert U1 und einem zweiten Wert U2 wechselt, ist mit einem Mittel 11 zum Erzeugen der Signalfolge S ausgestaltet. Das Mittel 11 ist derart konfiguriert, dass mittels eines vorgebbaren Sollwertes 1 eine erste Zeitdauer t1 während derer die Ausgangspannung U den ersten Wert U1 annimmt, berechnen kann. Zur Erzeugung der Signalfolge S ist dabei das Mittel 11 beispielsweise als ein Mikrocontroller ausgestaltet, welcher ein PWM-Modul aufweist. Weiterhin weist die Vorrichtung 10 ein Synchronisationsmittel 12 auf, welches ausgestaltet ist, die Erzeugung der Signalfolge S mit einer Sollwertberechnung des Sollwertes 1 zu synchronisieren. Der Sollwert 1 wird dabei von dem Automatisierungsgerät 30 bereitgestellt. In dem Automatisierungsgerät 30 ist als ein ablauffähiges Nutzerprogramm ein Regelalgorithmus 31 implementiert. Dieser Regelalgorithmus 31 stellt den Sollwert 1 bereit und über Kommunikationseinrichtungen des Automatisierungsgerätes 30 wird der Sollwert 1 über einen Feldbus 32 bis zu einem Interfacemodul 33 gesendet. Das Interfacemodul 33 ist zur einen Seite mit dem Feldbus 32 verbunden und zur anderen Seite mit einem Rückwandbus 34. Dieser Rückwandbus 34 ist Bestandteil eines Modulträgers 35. Die über das Interfacemodul 33 empfangenen Sollwerte 1 können mittels des Rückwandbusses 34 im gesamten Modulträger 35 für unterschiedliche Module bereitgestellt werden. Die Vorrichtung 10 bildet dabei ein Puls-Modul.

Ein Puls-Modul ermöglicht die Ansteuerung von Stellgliedern und Ventilen. Neben dem Puls-Modul ist ein weiteres Modul 36 schematisch angeordnet. Das Puls-Modul ist über eine Ausgangsleitung 38 mit Ein-/Ausgabeklemmen 37 verbunden. An die Ein-/Ausgabeklemmen 37 wird ein zu steuerndes Stellglied angeschlossen.

Das Synchronisationsmittel 12 und das Messmittel 15 sind auf einer Schaltungsanordnung 16 angeordnet. Die Schaltungsanordnung 16 kann die Funktionen des Synchronisationsmittels 12 und des Messmittels 15 entweder durch eine diskrete Aufbauweise erfüllen oder durch eine programmtechnische Implementierung in einen ASIC-Baustein. Auf jeden Fall weist das Synchronisationsmittel 12 einen Eingang 13 auf, an welchen ein Synchronisationssignal 14 anschaltbar ist. Durch die Anschaltung des Synchronisationssignals 14 und die Auswertung des Signals 14 innerhalb des Synchronisationsmittels 12 kann durch die Synchronisierung mit dem Sollwert 1, die Vorgabe einer Signalfolge S für ein angeschlossenes Stellglied durch das Mittel 11 zum Erzeugen der Signalfolge S derart abgestimmt werden, dass eine Totzeit minimiert wird. Wenn die Sollwertberechnung und die Erzeugung der Signalfolge S nicht aufeinander abgestimmt sind, entsteht zusätzlich zu den nötigen Signallaufzeiten, wie z.B. Buslaufzeit, Verarbeitungszeitdauer, eine Totzeit zwischen der Sollwertberechnung und der Ausgabe des PWM-Signals, deren Betrag zwischen Null und der Zeitdauer einer Periode T schwankt.

Durch die Synchronisation ist sichergestellt, dass eine neue Periode in der Signalfolge genau dann beginnt bzw. kurz vorher, wenn es erwartet wird.

Mit Hilfe des Synchronisationsmittels 12 ist es nun möglich dem Mittel 11 zum Erzeugen der Signalfolge S die Sollwerte 1 zu den Zeitpunkten zu übergeben, an denen eine Neuberechnung einer Signalfolge S ohne Totzeit möglich ist. Die Übergabe eines Sollwertes 1 an das Mittel 11 wird also immer zu Zeitpunkten erfolgen, an denen auch ein neuer Sollwert 1 bereitsteht. Das Puls-Modul ist also auf den Takt des Automatisierungsgerätes 30 synchronisiert.

Über eine Strommessleitung 39 wird dem Puls-Modul, also der Vorrichtung 10, eine Zustandsgröße I des angeschlossenen Stellgliedes bereitgestellt. Die Strommessleitung 39 wird durch die Vorrichtung 10 an das Messmittel 15 geführt, wobei in dem Messmittel 15 der Strom als eine Zustandsgröße I erfasst wird.

Da dass Synchronisationsmittel 12 mittels einer Synchronisationsverbindung 12a mit dem Messmittel 15 verbunden ist, ist auch die Strommessung der Zustandsgröße I mittels des Synchronisationssignales 14 synchronisiert.

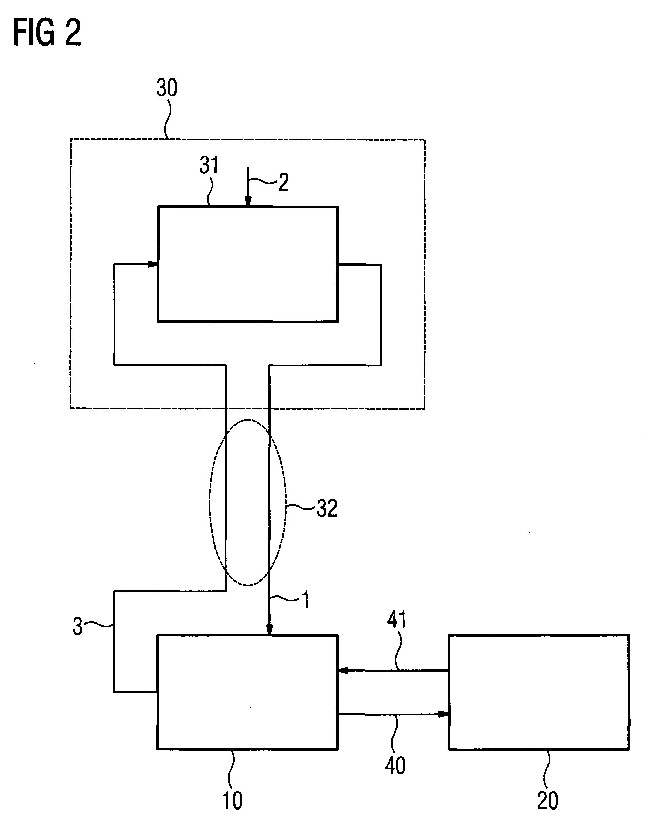

Gemäß FIG 2 wird der durch das Automatisierungsgerät 30 und der Vorrichtung 10 aufgebaute Regelkreis erläutert. An die Vorrichtung 10 ist über eine Leitung 40 zur Ausgabe der PWM-Signalfolge und über eine Leitung 41 zur Eingabe für die Strommessung ein Stellglied 20 angeschlossen, wobei das Stellglied 20 als ein Proportionalventil ausgestaltet ist. Über einen Feldbus 32 ist das Automatisierungsgerät 30 kommunikationstechnisch mit der Vorrichtung 10 verbunden. Über den Feldbus 32 kann das Automatisierungsgerät 30 die mittels des Regelalgorithmusses 31 berechneten Sollwerte 1 an die Vorrichtung 10 senden. Da die Vorrichtung 10 dazu ertüchtigt ist einen Strom zu messen, wird der gemessene Strom als eine Regelgröße 3 über den Feldbus 32 dem Regelalgorithmus 31 in dem Automatisierungsgerät 30 zugeführt. Die Vorrichtung 10 ist dabei, wie in FIG 1 beschrieben, ausgestaltet. Durch die Synchronisation des PWM-Signals werden unerwünschte Totzeiten bei der Ausgabe über die Leitung 40 eliminiert und die gleichzeitige Strommessung über die Leitung 41, welche auch synchron ausgeführt wird, filtert auf einfache und effektive Weise die Einschwingvorgänge, die innerhalb einer PWM-Periode auftreten, aus dem Messwert heraus. Beide Maßnahmen ergänzen sich und sorgen somit für eine hohe Qualität der Regelung.

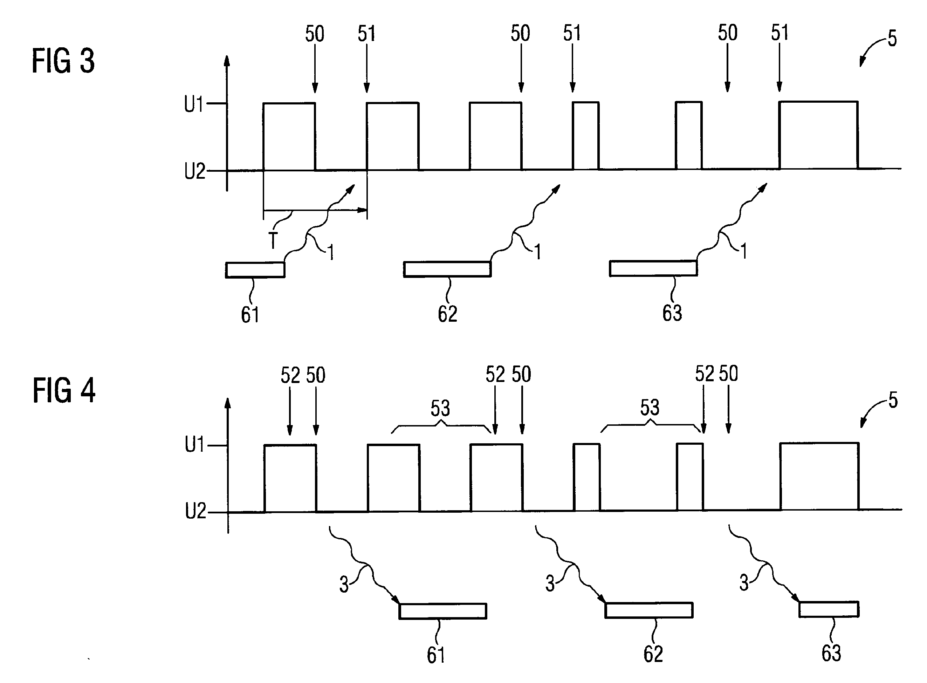

Mit der FIG 3 ist ein Schema für eine taktsynchrone PWM-Ausgabe dargestellt. In diesem Fall ist die PWM-Periode so eingestellt, dass genau zwei PWM-Perioden ausgegeben werden können, bis ein Feldbustakt 50 eintrifft. Beispielhaft ist an der ersten PWM-Signalfolge die Zeitdauer der Periode T eingetragen. Unterhalb des zeitlichen Verlaufes der Signalfolge S sind ebenfalls in zeitlicher Abfolge symbolisch ein erster Regleraufruf 61, ein zweiter Regleraufruf 62 und ein dritter Regleraufruf 63 abgebildet. Die Regleraufrufe 61,62,63 symbolisieren die Aufrufe des Regelalgorithmusses 31 im Automatisierungsgerät 30 (siehe FIG 1 und FIG 2).

Mit dem Abschluss des ersten Regleraufrufes 61 wird ein Sollwert 1 weitergeleitet, dabei soll die geschlängelte Linie des Sollwertes 1 symbolisieren, dass die Weiterleitung einer gewissen Laufzeit unterliegt. Die Laufzeit setzt sich beispielsweise aus Signallaufzeiten, Schaltzeiten der Ausgangstreiber und insbesondere Signallaufzeiten auf dem Feldbus 32 zusammen. Vorzugsweise wird hier die Totzeit eliminiert, welche bei einer asynchronen Vergabe eines Sollwertes an das Mittel 11 entstehen kann. Um eine unerwünschte Totzeit zu eliminieren, ist es dabei wesentlich, dass der Sollwert 1 kurz bevor oder zum Ausgabezeitpunkt 51 an der aus FIG 1 und FIG 2 bekannten Vorrichtung 10, also dem Puls-Modul, eintrifft. Es sei dabei davon ausgegangen, dass der Sollwert 1 hier unterschiedliche Werte annehmen kann, so ist der Sollwert 1, welcher nach dem zweiten Regleraufruf 62 abgesetzt wird, zu dem Vorgängersollwert unterschiedlich und wird damit eine von der Vorgänger PWM-Periode andersartige PWM-Periode hervorrufen. Es ist hier lediglich wieder wichtig, dass dieser veränderte Sollwert kurz vor oder zum Ausgabezeitpunkt 51 eintrifft. Bei einem weiteren dritten Regleraufruf 63 kann sich aufgrund der Regelung der Sollwert 1 wiederum verändert haben und er wird nach Beendigung des dritten Regleraufrufes 63 wiederum abgesetzt und erreicht ohne eine Totzeit das Mittel 11 zum erzeugen einer pulsweiten modulierten Signalfolge S in dem Puls-Modul. Es werden also neue Sollwerte mit einer neuen PWM-Periode, die zum Ausgabezeitpunkt 51 beginnt, wirksam.

Mit FIG 4 wird der schematische Verlauf einer Strommessung verdeutlicht. Eine Regelgröße 3, welche in diesem Fall ein Messwert der Strommessung ist, wird taktsynchron zum Feldbustakt 50 an den Feldbus 32 gelegt und erreicht passend zum Anfang des ersten Regleraufrufes 61 das Automatisierungsgerät 30. Während eines Zeitraumes 53 für die Mittelwertbildung wird ein erneuter Stromwert erfasst, wobei mit dem Eingabezeitpunkt 52 die Mittelwertbildung abgeschlossen wird und der neu ermittelte Stromwert wiederum als eine Regelgröße 3 im Feldbustakt 50 abgesetzt werden kann und damit genau zum Aufruf des zweiten Regleraufrufes 62 den Regelalgorithmus 31 in dem Automatisierungsgerät 30 erreicht. Diese synchronisierten Regleraufrufe und die synchronisierte Absetzung der Reglergröße 3 setzt sich fort bis zu einem dritten Regleraufruf 63.

Weitere Synchronisationsvorgaben, welche sich nicht zwingend auf den Beginn einer Periode beziehen, sind folgende:
Bei einer Änderung des Sollwertes berechnet die Vorrichtung 10 die neue Impulsdauer und Impulspause sofort. Beispielsweise würde bei einer Änderung des Sollwertes während der Impulspause für den Fall dass der neue Sollwert kleiner als der Vorgängersollwert ist, die Periodendauer einmalig verlängert werden, da die neue Pause länger wird. Würde hingegen eine Sollwertänderung während der Impulspause mit einem neuen Sollwert der größer ist als der alte Sollwert erfolgen, so würde die Periodendauer einmalig verkürzt, d.h. die Pause würde kleiner gewählt werden.

Bei einer Änderung während der Impulsdauer und bei einem Sollwert, welcher kleiner ist als sein Vorgängersollwert, könnte die Periodendauer einmal verlängert werden, da die Pause länger gewählt wird. Bei einer Änderung während der Impulsdauer und bei einem Sollwert, welcher größer ist als der Vorgängersollwert, bleibt die Periodendauer konstant.

Dies bedeutet, dass eine Synchronisation zur Änderung der PWM-Modulation nicht zwingend zu Beginn einer Periodendauer durchgeführt werden muss sondern es könnte das Tastverhältnis bzw. die Periode auch mitten in einer Periode aktualisiert werden.

## Patentansprüche

1. Verfahren zum Erzeugen einer pulsweiten modulierten Signalfolge (S) bei dem eine Ausgangsspannung (U) während einer Periode (T) zwischen einem ersten Wert (U1) und einem zweiten Wert (U2) wechselt, wobei mittels eines vorgebbaren Sollwertes (1) eine erste Zeitdauer (t1) während derer die Ausgangsspannung (U) den ersten Wert (U1) annimmt ermittelt wird, wobei die Erzeugung der Signalfolge (S) mit einer Sollwertberechnung des Sollwertes (1) synchronisiert wird,
**dadurch gekennzeichnet, dass**
die Sollwertberechnung in einem Automatisierungsgerät (30) durchgeführt wird und der Sollwert (1) zu Zeitpunkten bereitgestellt wird, welche ganzzahligen Vielfachen der Periode (T) entsprechen,
- wobei mit der Signalfolge (S) mit der ermittelten ersten Zeitdauer (t1) ein Stellglied (20) angesteuert wird,
- wobei der Sollwert (1) über einen Regelalgorithmus (31) bereitgestellt wird und die Ausgangsspannung (U) mittels einer Zustandsgröße (I) des Stellgliedes (20) geregelt wird,
- wobei über eine Strommessleitung (39) einer Vorrichtung (10) die Zustandsgröße (I) bereitgestellt wird,
- wobei die Zustandsgröße (I) als eine Regelgröße (3) über einen Feldbus (32) dem Regelalgorithmus (31) in dem Automatisierungsgerät (30) taktsynchron zu einem Feldbustakt (50) bereitgestellt wird, wodurch die Regelgröße (3) passend zum Anfang eines Regleraufrufes (61) das Automatisierungsgerät (30) erreicht,
- wobei über ein Betriebssystem des Automatisierungsgerätes (30) die Sollwertberechnung synchron zu dem Takt (50) des Feldbusses (32) ausgeführt wird,
- und der errechnete Sollwert (1) anschließend über den Feldbus (32) wieder bereitgestellt wird,
- wobei über ein Synchronisationsmittel (12) die Erzeugung der Signalfolge (S) mit der Sollwertberechnung synchronisiert wird.

2. Verfahren nach Anspruch 1, wobei die Erfassung der Zustandsgröße (I) derart synchronisiert wird, dass für die Zeitdauer einer Periode (T) eine Mittelwertbildung für die Zustandsgröße (I) durchgeführt wird.

3. Automatisierungssystem mit einem Automatisierungsgerät (30) und mit einer Vorrichtung (10) zur Ausgabe einer pulsweiten modulierten Signalfolge (S) bei dem eine Ausgangsspannung (U) während einer Periode (T) zwischen einem ersten Wert (U1) und einem zweiten Wert (U2) wechselt,
wobei die Vorrichtung (10) ein Mittel (11) zum Erzeugen der Signalfolge(S) aufweist, welches ausgestaltet ist mittels eines vorgebbaren Sollwertes (1) eine erste Zeitdauer (t1) während derer die Ausgangsspannung (U) den ersten Wert (U1) annimmt zu berechnen, die Vorrichtung (10) weist weiterhin ein Synchronisationsmittel (12) auf, welches ausgestaltet ist die Erzeugung der Signalfolge (S) mit einer Sollwertberechnung des Sollwertes (1) zu synchronisieren
**dadurch gekennzeichnet, dass**
das Synchronisationsmittel (12) einen Eingang (13) aufweist, an welchen ein Synchronisationssignal (14) anschaltbar ist,
- wobei das Automatisierungsgerät (30) über einen Feldbus (32) mit der Vorrichtung (10) verbunden ist,
- das Automatisierungsgerät (30) dazu ausgestaltet ist, den Sollwert (1) über den Feldbus (32) bereitzustellen, wobei an dem Eingang (13) ein Taktsignal (50) des Feldbusses (32) angeschaltet ist,
- die Vorrichtung (10) ein Messmittel (15) zum Messen einer Zustandsgröße (I) eines Stellgliedes (20) aufweist, weiterhin ist die Vorrichtung (10) dazu ausgestaltet die Zustandsgröße (I) als eine Regelgröße (3) über den Feldbus (32) dem Automatisierungsgerät (30) zuzuführen, weiterhin weist das Automatisierungsgerät (30) einen Regelalgorithmus (31) zur Berechnung des Sollwertes (1) auf und ist ausgestaltet den berechneten Sollwert (1) an die Vorrichtung (10) zu senden, das Synchronisationsmittel (12) ist dazu ausgestaltet die Erzeugung der Signalfolge (S) mit der Sollwertberechnung zu synchronisieren, dabei weist das Automatisierungsgerät (30) ein Betriebssystem auf, welches ausgestaltet ist, ein die Sollwertberechnung synchron zu dem Takt (50) des Feldbusses (32) auszuführen.

4. Automatisierungsgerät (30) nach Anspruch 3, wobei das Synchronisationsmittel (12) weiterhin dazu ausgestaltet ist, dass die Ausgabe der Signalfolge (S) zu Zeitpunkten durchführbar ist, welche ganzzahligen Vielfachen der Periode (T) entsprechen.

5. Automatisierungsgerät (30) nach Anspruch 3 oder 4, wobei zwischen dem Messmittel (15) und dem Synchronisationsmittel (12) eine Synchronisationsverbindung (12a) besteht, wobei die Erfassung der Zustandsgröße (I) derart synchronisiert wird, dass für die Zeitdauer einer Periode (T) eine Mittelwertbildung für die Zustandsgröße (I) durchgeführt wird.

6. Automatisierungsgerät (30) nach einem der Ansprüche 3 bis 5, wobei das Synchronisationsmittel (12) dazu ausgestaltet ist Eigenschaften des Synchronisationssignals (14) auszuwerten und an die Eigenschaften angepasste Parameter für die Signalfolge (S) bereitzustellen.

## Claims

1. Method for generating a pulse-width modulated signal sequence (S) in which an output voltage (U), during a period (T), changes between a first value (U1) and a second value (U2), wherein, by means of a predeterminable setpoint value (1), a first duration (t1) is determined, during which the output voltage (U) assumes the first value (U1), wherein the generation of the signal sequence (S) is synchronised with a setpoint value calculation of the setpoint value (1),
**characterised in that**
the setpoint value calculation is implemented in an automation device (30) and the setpoint value (10) is provided at time instances which correspond to whole number multiples of the period (T),
- wherein, an actuating element (20) is activated using the signal sequence (S) with the determined first duration (t1),
- wherein the setpoint value (1) is provided by way of a control algorithm (31) and the output voltage (U) is controlled by means of a state variable (I) of the actuating element (20),
- wherein the state variable (I) is provided via a current measuring line (39) of an apparatus (10),
- wherein the state variable (I) as a control variable (3) is provided in the automation device (30) in synchrony with a field bus pulse (50) via a field bus (32) to the control algorithm (31), as a result of which the control variable (3) reaches the automation device (30) appropriately for the start of a controller call-up (61),
- wherein the setpoint value calculation is executed in synchrony with the pulse (50) of the field bus (32) via an operating system of the automation device (30),
- and the calculated setpoint value (10) is then provided again via the field bus (32),
- wherein, generation of the signal sequence (S) is synchronised with the setpoint value calculation via a synchronisation means (12).

2. Method according to claim 1, wherein detection of the state variable (I) is synchronised such that an average value formation for the state variable (I) is implemented for the duration of a period (T).

3. Automation system having an automation device (30) and an apparatus (10) for outputting a pulse-width modulated signal sequence (S) in which an output voltage (U), during a period (T), changes between a first value (U1) and a second value (U2), wherein the apparatus (10) comprises a means (11) for generating the signal sequence (S), which is embodied to calculate, by means of a predeterminable setpoint value (1), a first duration (t1) during which the output voltage (U) assumes the first value (U1), the apparatus (100) also comprises a synchronisation means (12), which is embodied to synchronise generation of the signal sequence (S) with a setpoint value calculation of the setpoint value (1),
**characterised in that**
the synchronisation means (12) comprises an input (13), to which a synchronisation signal (14) can be connected,
- wherein the automation device (30) is connected to the apparatus (10) via a field bus (32),
- the automation device (30) is configured to provide the setpoint value (1) via the field bus (32), wherein a pulse signal (50) of the field bus (32) is connected to the input (13),
- the apparatus (10) comprises a measuring means (15) for measuring a state variable (I) of an actuating element (20), furthermore the apparatus (10) is embodied to supply the state variable (I) as a control variable (3) via the field bus (32) to the automation device (30), furthermore, the automation device (30) comprises a control algorithm (31) for calculating the setpoint value (1) and is embodied to send the calculated setpoint value (1) to the apparatus (10), the synchronisation means (12) is embodied to synchronise generation of the signal sequence (S) with the setpoint value calculation, the automation device (30) comprising an operating system, which is embodied to execute the setpoint value calculation in synchrony with the pulse (50) of the field bus (32).

4. Automation device (30) according to claim 3, wherein the synchronisation means (12) is also embodied such that the signal sequence (S) can be output at time instances, which correspond to whole number multiples of the period (T).

5. Automation device (30) according to claim 3 or 4, wherein a synchronisation link (12a) exists between the measuring means (15) and the synchronisation means (12), wherein the detection of the state variable (I) is synchronised such that an average value formation for the state variable (I) is implemented for the duration of a period (T).

6. Automation device (30) according to one of claims 3 to 5, wherein the synchronisation means (12) is embodied to evaluate properties of the synchronisation signal (14) and to provide parameters adjusted to the properties for the signal sequence (S).

## Revendications

1. Procédé de production d'une séquence ( S ) de signal à modulation d'impulsion en durée, dans lequel une tension ( U ) de sortie alterne pendant une période ( T ) entre une première valeur ( U1 ) et une deuxième valeur ( U2 ), dans lequel on détermine au moyen d'une valeur ( 1 ) de consigne pouvant être prescrite une première durée ( t1 ) pendant laquelle la tension ( U ) de sortie prend la première valeur ( U1 ), dans lequel on synchronise la production de la séquence ( S ) de signal avec un calcul de la valeur ( 1 ) de consigne,
**caractérisé en ce que**
on effectue le calcul de la valeur de consigne dans un appareil ( 30 ) d'automatisation et on met à disposition la valeur ( 1 ) de consigne aux instants qui correspondent à des multiples en nombre entier de la période ( T ),
- dans lequel on commande un élément ( 20 ) de réglage par la séquence ( S ) de signal ayant la première durée ( t1 ) déterminée,
- dans lequel on met à disposition la valeur ( 1 ) de consigne par un algorithme ( 31 ) de réglage et on règle la tension ( U ) de sortie au moyen d'une grandeur ( 1 ) d'état de l'élément ( 20 ) de réglage,
- dans lequel on met à disposition la grandeur ( I ) d'état par une ligne ( 39 ) de mesure du courant d'un dispositif ( 10 ),
- dans lequel la grandeur ( I ) d'état est, en tant que grandeur ( 3 ) de réglage, mise à disposition par un bus ( 32 ) de terrain de l'algorithme ( 31 ) de réglage dans l'appareil ( 30 ) d'automatisation en synchronisme avec une cadence ( 50 ) du bus de terrain, de manière à ce que la grandeur ( 3 ) de réglage atteigne l'appareil ( 30 ) d'automatisation en s'adaptant au début d'un appel ( 61 ) de régleur,
- dans lequel on exécute, par un système pour faire fonctionner l'appareil d'automatisation, le calcul de la valeur de consigne en synchronisme à la cadence ( 50 ) du bus ( 32 ) de terrain,
- et on remet ensuite, par le bus ( 32 ) de terrain, à disposition la valeur ( 1 ) de consigne calculée,
- dans lequel on synchronise, par un moyen ( 12 ) de synchronisation, la production de la séquence ( S ) de signal avec le calcul de la valeur de consigne.

2. Procédé suivant la revendication 1, dans lequel on synchronise la détection de la grandeur ( I ) d'état, de manière à effectuer une moyenne de la grandeur ( I ) d'état pendant la durée d'une valeur ( T ).

3. Système d'automatisation comprenant un appareil ( 30 ) d'automatisation et un dispositif ( 10 ) d'émission d'une séquence ( S ) de signal à modulation d'impulsion en durée, dans lequel une tension ( U ) de sortie alterne pendant une période ( T ) entre une première valeur ( U1 ) et une deuxième valeur ( U2 ),
le dispositif ( 10 ) ayant un moyen ( 11 ) de production de la séquence ( S ) de signal qui est conformé pour calculer, au moyen d'une valeur ( 1 ) de consigne pouvant être prescrite, une première durée ( t1 ) pendant laquelle la tension ( U ) de sortie prend la première valeur ( U1 ), le dispositif ( 10 ) comprenant, en outre, un moyen ( 12 ) de synchronisation qui est conformé pour synchroniser la production de la séquence ( S ) de signal avec un calcul de la valeur ( 1 ) de consigne,
**caractérisé en ce que**
le moyen ( 12 ) de synchronisation a une entrée ( 13 ), à laquelle peut être appliqué un signal ( 14 ) de synchronisation,
- dans lequel l'appareil ( 30 ) d'automatisation est relié au dispositif ( 10 ) par un bus ( 32 ) de terrain,
- l'appareil ( 30 ) d'automatisation est tel qu'il met la valeur ( 1 ) de consigne à disposition par l'intermédiaire du bus ( 12 ) de terrain, un signal ( 50 ) de cadencement du bus ( 32 ) de terrain étant appliqué à l'entrée ( 13 ),
- le dispositif ( 10 ) a un moyen ( 15 ) de mesure d'une grandeur ( I ) d'état d'un élément ( 10 ) de réglage, le dispositif ( 10 ) étant, en outre, conformé pour envoyer la grandeur ( I ) d'état en tant que grandeur ( 3 ) de réglage à l'appareil ( 30 ) d'automatisation par l'intermédiaire du bus ( 32 ) de terrain, l'appareil ( 30 ) d'automatisation ayant, en outre, un algorithme ( 31 ) de réglage pour le calcul de la valeur ( 1 ) de consigne et étant conformé pour envoyer la valeur ( 1 ) de consigne calculée au dispositif ( 10 ), le moyen ( 12 ) de synchronisation étant conformé pour synchroniser la production de la séquence ( S ) de signal au calcul de la valeur de consigne, l'appareil ( 30 ) d'automatisation ayant un système pour le faire fonctionner qui est conformé pour exécuter le calcul de la valeur de consigne en synchronisme à la cadence ( 50 ) du bus ( 32 ) de terrain.

4. Appareil ( 30 ) d'automatisation suivant la revendication 3, dans lequel le moyen ( 12 ) de synchronisation est, en outre, conformé de manière à pouvoir exécuter l'émission de la séquence ( S ) de signal à des instants qui correspondent à des multiples en nombre entier de la période ( T ).

5. Appareil ( 30 ) d'automatisation suivant la revendication 3 ou 4, dans lequel il y a une liaison ( 12a ) de synchronisation entre le moyen ( 15 ) de mesure et le moyen ( 12 ) de synchronisation, la détection de la grandeur ( I ) d'état étant synchronisée de manière à effectuer une moyenne de la grandeur ( I ) d'état pendant la durée d'une période ( T ).

6. Appareil ( 30 ) d'automatisation suivant l'une des revendications 3 à 5, dans lequel le moyen ( 12 ) de synchronisation est conformé pour exploiter des propriétés du signal ( 14 ) de synchronisation et pour mettre à disposition des paramètres de la séquence ( S ) du signal adaptés aux propriétés.
